# EUROPÄISCHE PATENTSCHRIFT

(11) **EP 1 147 596 B1**
(45) Veröffentlichungstag und Bekanntmachung des Hinweises auf die Patenterteilung: **02.10.2002**
(21) Anmeldenummer: 99964356.2
(22) Anmeldetag: 22.11.1999
(51) Int. Cl.: H02M 1/088

(54) **VERFAHREN ZUR VERRINGERUNG VON VERLUSTEN BEIM KOMMUTIERUNGSVORGANG**
METHOD FOR REDUCING LOSSES IN COMMUTATION PROCESSES
PROCEDE POUR REDUIRE LES PERTES LORS D'UNE COMMUTATION

(30) Priorität: 03.12.1998 DE 19855900
(43) Veröffentlichungstag der Anmeldung: 24.10.2001
(73) Patentinhaber: SIEMENS AKTIENGESELLSCHAFT, 80333 München (DE)
(72) Erfinder: BAUDELOT, Eric, D-91085 Weisendorf (DE); BRUCKMANN, Manfred, D-90475 Nürnberg (DE); MITLEHNER, Heinz, D-91080 Uttenreuth (DE); WEIS, Benno, D-91334 Hemhofen (DE)
(86) Internationale Anmeldenummer: DE9903707
(87) Internationale Veröffentlichungsnummer: WO00033449

(56) Entgegenhaltungen:
- FR-A- 2 693 325
- DATABASE INSPEC [Online] INSTITUTE OF ELECTRICAL ENGINEERS, STEVENAGE, GB CITTADINI R ET AL: "A matrix converter switching controller for low losses operation without snubber circuits" Database accession no. 6390168 XP000881443 & EPE'97. 7TH EUROPEAN CONFERENCE ON POWER ELECTRONICS AND APPLICATIONS, PROCEEDINGS OF 7TH EUROPEAN CONFERENCE ON POWER ELECTRONICS AND APPLICATIONS, TRONDHEIM, NORWAY, 8-10 SEPT. 1997, Seiten 199-203 vol.4, 1997, Brussels, Belgium, EPE Assoc, Belgium ISBN: 90-75815-02-6

## Beschreibung

Die Erfindung bezieht sich auf ein Verfahren zur Verringerung von Verlusten bei der Kommutierung eines im Freilauf arbeitenden, angesteuerten Stromrichterventils einer Wechselrichterphase auf ein stromübernehmendes Stromrichterventil dieser Wechselrichterphase.

Aus der Veröffentlichung mit dem Titel "Use of the MOSFET Channel Reverse Conduction in an Inverter for Suppression of the Integral Diode Recovery Current", abgedruckt im Konferenzbericht "The European Power Electronics Association", 13. Bis 16.09.1993 in Brighton, Seiten 431 bis 436, ist ein Verfahren bekannt, mit dem beim Kommutierungsvorgang Verluste verringert werden. Dieses bekannte Verfahren wird bei einem mehrphasigen Wechselrichter angewendet, der als Stromrichterventil Metalloxidschicht-Feldeffekttransistoren (MOSFET) aufweist.

MOSFET sind unipolare Leistungshalbleiter, die in der Lage sind, Strom in beiden Richtungen zu führen. Parasitär besitzt jeder MOSFET eine antiparallele bipolare Freilaufdiode, die allgemein als Inversdiode bezeichnet wird. Diese Freilaufdiode weist Eigenschaften auf, die für den Betrieb des Stromrichterventils nicht optimal sind, da sie nicht als eigener Chip in einem eigenen Prozeß hergestellt werden kann. Sie ist integraler Bestandteil des MOSFET. Diese Inversdiode weist ein nicht optimales Durchlaßverhalten und eine nicht optimierte Speicherladung auf.

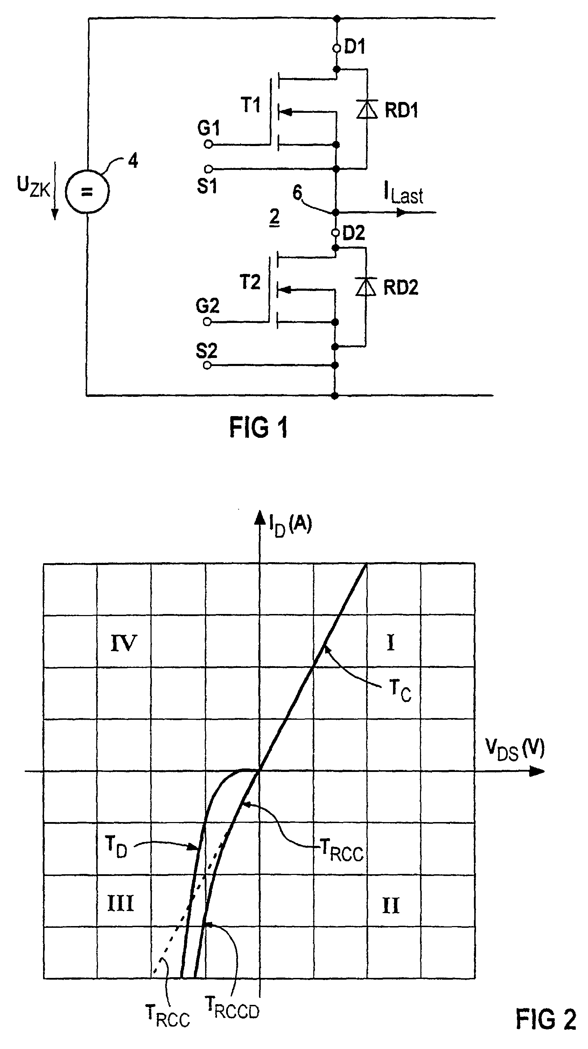

In der FIG 1 ist eine bekannte Schaltung einer Wechselrichterphase 2, die als Stromrichterventile T1 und T2 jeweils ein MOSFET aufweist, näher dargestellt. Die antiparallele bipolare Freilaufdiode des Stromrichterventils T1 bzw. T2 ist mit RD1 bzw. RD2 bezeichnet. Diese Wechselrichterphase 2 ist gleichspannungsseitig mit einer Gleichspannungsquelle 4 verknüpft, an der eine Gleichspannung U_{ZK}, die auch als Zwischenkreisspannung bezeichnet wird, abfällt. Der Verbindungspunkt 6 der beiden elektrisch in Reihe geschalteten Stromrichterventile T1 und T2 bildet einen Wechselstromanschluß, an dem eine Last anschließbar ist. Bei den verwendeten MOSFET handelt es sich um selbstsperrende, die als Enhancement-MOSFET bezeichnet werden. Ein Drainstrom fließt bei n-Kanal-Enhancement-MOSFET erst dann, wenn die Gate-Source-Spannung U_{GS} einen vorbestimmten positiven Wert überschreitet.

In der FIG 2 ist eine Strom-Spannungs-Charakteristik eines MOSFET dargestellt, die aus dem eingangs genannten Konferenzbericht "EPE" bekannt ist. Diese Strom-Spannungs-Charakteristik weist verschiedene Kennlinien auf, die im Quadranten I und III verlaufen. Der Teil der Kennlinie im Quadranten I, der mit Tc bezeichnet ist, wird benutzt, wenn der MOSFET mittels einer Gate-Source-Spannung U_{GS} = 15 V angesteuert wird. Der Teil der Kennlinie im Quadranten III der mit T_{RCC} bezeichnet ist, wird benutzt, wenn der MOSFET angesteuert wird und ein Laststrom I_{LAST} entgegen der Hauptrichtung durch den MOSFET fließt. Wird der MOSFET nicht angesteuert (U_{GS} = 0 V), so wird die Kennlinie im Quadranten III benutzt, die mit T_{D} bezeichnet ist. Das heißt, die integrale Freilaufdiode RD des MOSFET führt den Laststrom I_{LAST}.

Gemäß dieser Charakteristik ist erkennbar, daß die Durchlaßverluste eines MOSFET verringert werden können, wenn im Freilaufbetrieb der MOSFET angesteuert wird. Dadurch teilt sich der Freilaufstrom auf den Transistor und der integralen Freilaufdiode RD auf. Dieser Betrieb ist durch die Kennlinie T_{RCCD} im Quadranten III gekennzeichnet.

Beim Kommutierungsvorgang vom Stromrichterventil T2, das im Freilauf arbeitet und angesteuert ist, auf das stromübernehmende Stromrichterventil T1 (FIG 1) muß gemäß der Veröffentlichung "Commutation Behaviour in DC/AC-Converters with Power MOSFET", abgedruckt in "PCI", Juni 1986, Seiten 316 bis 330, zunächst das Stromrichterventil T2 abgeschaltet werden, bevor das Stromrichterventil T1 eingeschaltet werden darf. Dies ist erforderlich, um einen Kurzschluß durch gleichzeitiges Einschalten der beiden Stromrichterventile T1 und T2 zu verhindern. Dies bedeutet, daß zum Zeitpunkt der Kommutierung die integrale Freilaufdiode RD des im Freilauf arbeitende Stromrichterventils T2 den Laststrom I_{LAST} führt und damit aufgrund der gespeicherten Ladung die Freilaufdiode RD Abschaltverluste verursacht.

In der eingangs genannten Veröffentlichung ist ein Verfahren angegeben, wodurch der Laststrom I_{LAST} beim Kommutierungsvorgang vom im Freilauf arbeitenden, angesteuerten Stromrichterventil T2 auf das stromübernehmende Stromrichterventil T1 nicht von der integralen Freilaufdiode RD2 des Stromrichterventils T2 geführt wird. Dieses bekannte Verfahren ist dadurch gekennzeichnet, daß das stromübernehmende Stromrichterventil T1 so langsam angesteuert wird, daß nur ein minimaler Stromüberschwinger auftritt. Durch das langsame Ansteuern des stromübernehmenden Stromrichterventils T1 steigt dessen Einschaltverluste an. Die Höhe dieser Einschaltverluste sind von der Verzögerung des Einschaltens abhängig. Der Stromüberschwinger ist vergleichbar mit einem Diodenrückstrom, der das Stromrichterventil T1 zusätzlich belastet. Für diese zeitlich ausgedehnte Ansteuerung wird für jedes Stromrichterventil T1 und T2 einer Wechselrichterphase 2 eine Überstromerfassung benötigt. Dieser Strom im Brückenzweig wird mittels einer Spannungsmessung an einer Streuinduktivität erfaßt. Dazu muß einerseits der Wert der Streuinduktivität genau bekannt sein und andererseits muß ein schneller Integrator vorgesehen sein, an dessen Ausgang dann der Wert des Stromes im Brückenzweig ansteht. Diesem Integrator ist ein Spitzenwertdetektor nachgeschaltet, der ausgangsseitig mit einer Überstrom-Steuereinrichtung verbunden ist. Durch dieses Verfahren vermindert sich die Amplitude des Sperrverzögerungsstromes und die Schaltverluste des im Freilauf arbeitenden, angesteuerten Stromrichterventils beim Kommutierungsvorgang.

Der Erfindung liegt nun die Aufgabe zugrunde, das bekannte Verfahren derart abzuändern, daß die genannten Nachteile nicht mehr auftreten.

Diese Aufgabe wird erfindungsgemäß dadurch gelöst, daß zu Beginn des Kommutierungsvorganges das stromübernehmende Stromrichterventil eingeschaltet und daß das im Freilauf arbeitende, angesteuerte Stromrichterventil schnell abgeschaltet wird, sobald der Wert seiner Drainspannung gleich Null ist.

Als Meßwert für dieses Verfahren wird die Drainspannung des im Freilauf arbeitenden Stromrichterventils benötigt. Dieser Meßwert wird bei der bekannten Entsättigungsüberwachung, mit der ein Kurzschluß- bzw. ein Überstrom erfaßt wird, verwendet. Das heißt, man benötigt keine weitere Meßwert-Erfassungseinrichtung, um das erfindungsgemäße Verfahren durchführen zu können.

Durch die Ansteuerung des stromübernehmenden Stromrichterventils kommutiert der Laststrom vom im Freilauf arbeitenden Stromrichterventil auf das stromübernehmende Stromrichterventil. In Abhängigkeit dieser Stromkommutierung verändert sich der Wert der Drainspannung des im Freilauf arbeitenden Stromrichterventils. Zum Beginn der Kommutierung weist die Drainspannung einen negativen Wert in der Größenordnung der Sättigungsspannung des Stromrichterventils auf. Am Ende der Laststromkommutierung fällt an diesem Stromrichterventil die gesamte Zwischenkreisspannung als Sperrspannung ab, da das stromübernehmende Stromrichterventil den Laststrom führt. Aus diesen beiden Eckwerten der Drainspannung ist zu erkennen, daß der Verlauf der Drainspannung während des Kommutierungsvorgangs einen Nulldurchgang aufweist. Exakt zu diesem Zeitpunkt ist der Laststrom vollständig auf das stromübernehmende Stromrichterventil kommutiert.

Damit die Abschaltverluste möglichst minimal werden, muß zu diesem Zeitpunkt das im Freilauf arbeitende Stromrichterventil so schnell wie möglich abgeschaltet werden. In Abhängigkeit der Schnelligkeit dieser Abschaltung fließt ein Querstrom durch das im Freilauf arbeitende Stromrichterventil und durch das stromübernehmende Stromrichterventil zusätzlich zum Laststrom. Das heißt, die auftretenden Verluste können nicht eliminiert werden, sondern nur in Abhängigkeit der Schnelligkeit der Abschaltung des im Freilauf arbeitenden Stromrichterventils verringert werden. Diese Verringerung der Verluste ist gegenüber der Verringerung mittels des bekannten Verfahrens wesentlich größer, da beim bekannten Verfahren einerseits Verarbeitungsschritte für das Meßsignal vorhanden sind und andererseits die Überstrom-Steuereinrichtung erst dann arbeiten kann, wenn bereits ein Überstrom aufgetreten ist.

Bei einem vorteilhaften Verfahren wird zu Beginn des Kommutierungsvorgangs die Gatespannung des im Freilauf arbeitenden, angesteuerten Stromrichterventils soweit abgesenkt, bis seine Drainspannung gleich einer vorbestimmten Referenzspannung ist. Durch diesen zusätzlichen Verfahrensschritt verbessert sich die Erkennung des Spannungsnulldurchgangs der Drainspannung wesentlich, da unabhängig vom Wert der Sättigungsspannung des im Freilauf arbeitenden, angesteuerten Stromrichterventils der Ausgangswert der Drainspannung zu Beginn des Kommutierungsvorgangs immer den Wert der Referenzspannung aufweist. Dies macht sich besonders bei kleinen Lastströmen bemerkbar.

Zur näheren Erläuterung der Erfindung wird auf die Zeichnung bezug genommen, in der das Verfahren nach der Erfindung schematisch veranschaulicht ist.
- FIG 1: zeigt eine bekannte Wechselrichterphase, die
- FIG 2: zeigt eine bekannte Strom-Spannungs-Charakteristik des Stromrichterventils T2 der FIG 1, in
- FIG 3: ist in einem Diagramm über die Zeit t der Verlauf der Gate-Source-Spannung des Stromrichterventils T2 der FIG 1 beim Kommutierungsvorgang gemäß der Erfindung und in
- FIG 4: ist in einem Diagramm über der Zeit t der Verlauf der zugehörigen Drainspannung dargestellt, in den
- FIG 5,6: sind die Verläufe der Drain-Source-Spannung und der Drainspannung jeweils in einem Diagramm über der Zeit t gemäß einer vorteilhaften Ausführungsform des erfindungsgemäßen Verfahrens dargestellt und die
- FIG 7: zeigt die Schaltung einer bekannten Hybrid-Leistungs-MOSFET.

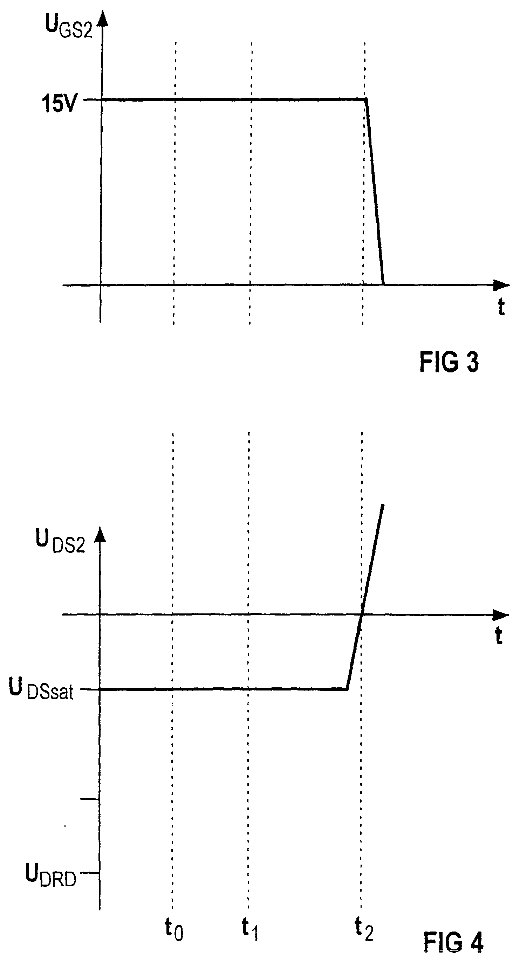

Anhand der Diagramme der FIG 3 und 4 in Verbindung mit der Schaltungsanordnung nach FIG 1 wird nun das erfindungsgemäße Verfahren näher erläutert:

Zum Zeitpunkt t₀ ist das Stromrichterventil T1 gesperrt und das Stromrichterventil T2 angesteuert. Unter der Voraussetzung, daß der Laststrom I_{LAST} > 0 ist, arbeitet das Stromrichterventil T2 im Freilauf und führt den Laststrom ILAST entgegen seiner Hauptrichtung. Die integrale Freilaufdiode RD2 ist gemäß dem Diagramm nach FIG 2 in Abhängigkeit des fließenden Drainstromes I_{D} an der Stromführung beteiligt. Das Stromrichterventil T1 ist das Stromrichterventil, das bei dem Kommutierungsvorgang den Laststrom I_{LAST} übernehmen soll. Deshalb wird dieses Stromrichterventil T1 als das stromübernehmende Stromrichterventil bezeichnet. Als Stromrichterventile T1 und T2 sind Si-MOSFET vorgesehen, die - wie eingangs bereits erwähnt - zu den unipolaren Leistungshalbleitern gezählt werden, die Strom in beiden Richtungen (Drain-Source, Source-Drain) führen können. Zum Zeitpunkt t₁ wird das stromübernehmende Stromrichterventil T1 angesteuert, wodurch dieses einschaltet. Mit dieser Ansteuerung des stromübernehmenden Stromrichterventils T1 wird der Verlauf der Drain-Source-Spannung U_{DS2} hinsichtlich eines Spannungsnulldurchganges überwacht. Zum Zeitpunkt t₂ tritt dieser Spannungsnulldurchgang bei der Drainspannung U_{DS2} des im Freilauf arbeitenden Stromrichterventils T2 auf. Zu diesem Zeitpunkt t₂ wird das im Freilauf arbeitende Stromrichterventil T2 abgeschaltet. Diese Abschaltung sollte so schnell wie möglich ausgeführt werden. Ist das im Freilauf arbeitende Stromrichterventil T2 abgeschaltet, fällt an diesem Stromrichterventil die gesamte Zwischenkreisspannung U_{ZK} ab und das stromübernehmende Stromrichterventil T1 führt den gesamten Laststrom I_{LAST}.

Wie man dem Diagramm gemäß FIG 4 entnehmen kann, fällt am im Freilauf arbeitenden, angesteuerten Stromrichterventil T2 betragsmäßig eine Sättigungsspannung U_{DSsat} ab. Der Wert dieser Sättigungsspannung U_{DSsat} ist bei selbstsperrenden MOSFET vom Drainstrom I_{D} abhängig. Je kleiner der Drainstrom I_{D} ist, um so kleiner ist der Wert der Sättigungsspannung U_{DSsat}. Je kleiner jedoch der Wert dieser Sättigungsspannung U_{DSsat} ist, um so schwieriger ist die Erkennung des Spannungsnulldurchgangs. Wird der Spannungsnulldurchgang erst nach dem Zeitpunkt t₂ erkannt, so liegt ein Brückenkurzschluß vor und beide Stromrichterventile T1 und T2 können eventuell wegen Überstrom abgeschaltet werden. Wird der Spannungsnulldurchgang vor dem Zeitpunkt t₂ erkannt, so kommutiert der durch das Stromrichterventil T2 fließende Laststrom I_{LAST} vollständig auf die integrale Freilaufdiode RD2, wodurch wieder Abschaltverluste aufgrund der gespeicherten Ladung dieser Freilaufdiode RD2 verursacht werden.

Aus diesen genannten Gründen, ist das erfindungsgemäße Verfahren derart verbessert worden, daß unabhängig vom Drainstrom I_{D} zum Zeitpunkt der Ansteuerung des stromübernehmenden Stromrichterventils T1 die Drain-Source-Spannung U_{DS} des im Freilauf arbeitenden Stromrichterventils T2 einen vorbestimmten Wert einnimmt. Dieser als Referenzwert U_{DSref} bezeichnete Wert ist betragsmäßig größer als eine Sättigungsspannung U_{DSsat}, jedoch kleiner als die Durchlaßspannung U_{DRD} der integralen Freilaufdiode RD2.

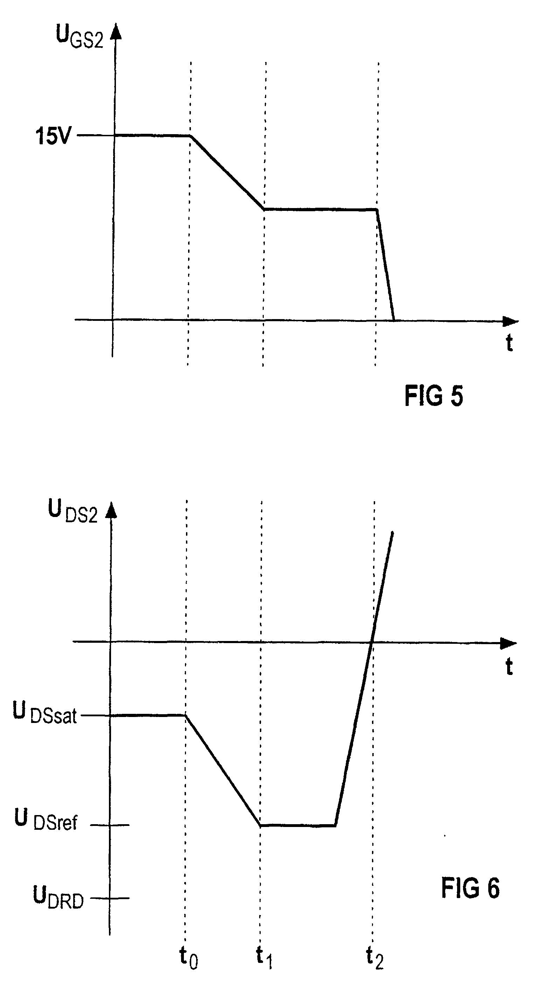

Damit zum Zeitpunkt der Ansteuerung des stromübernehmenden Stromrichterventils T1 die Drain-Source-Spannung U_{DS} gleich der Referenzspannung U_{DSref} ist, wird zu Beginn des Kommutierungsvorgangs, d.h. zum Zeitpunkt t₀ gemäß FIG 5, die Gate-Source-Spannung U_{GS2} des im Freilauf arbeitenden Stromrichterventils T2 soweit abgesenkt, bis seine Drain-Source-Spannung U_{DS2} gleich der Referenzspannung U_{DSref} ist. Zum Zeitpunkt t₁ der FIG 6 ist die Drain-Source-Spannung U_{DS2} des im Freilauf arbeitenden Stromrichterventils T2 betragsmäßig bis auf den Wert der Referenzspannung U_{DSref} angestiegen. Nachdem der Wert der Drain-Source-Spannung U_{DS2} des im Freilauf arbeitenden Stromrichterventils T2 gleich dem vorbestimmten Wert der Referenzspannung U_{DSref} ist, wird das stromübernehmende Stromrichterventil T1 eingeschaltet. Mit dem Einschalten des stromübernehmenden Stromrichterventils T1 wird der Verlauf der Drainspannung U_{DS2} hinsichtlich eines Spannungsnulldurchgangs überwacht. Sobald die Drainspannung U_{DS2} den Wert Null erreicht hat (Zeitpunkt t₂ der FIG 6), wird das im Freilauf arbeitende Stromrichterventil T2 so schnell wie möglich abgeschaltet. Durch die erfindungsgemäße Absenkung der Gate-Source-Spannung U_{GS2} des im Freilauf arbeitenden Stromrichterventils T2 wird seine Drain-Source-Spannung U_{DS2} auf einen vorbestimmten Wert U_{DSref} gebracht. Somit wird dieses erfindungsgemäße Verfahren unabhängig vom fließenden Drainstrom I_{D}.

Werden als Stromrichterventile T1 und T2 MOSFET aus Silizium verwendet, beträgt die Schwellspannung U_{DRD} der integralen Freilaufdiode RD1 und RD2 ungefähr 0,7 V. Werden jedoch MOSFET aus Siliziumcarbid verwendet, so beträgt die Schwellspannung U_{DRD} der integralen Freilaufdiode RD1 und RD2 ungefähr 2,8 V. Diese höhere Schwellspannung U_{DRD} ergibt sich daraus, da Siliziumcarbid einen sehr viel größeren Bandabstand als Silizium aufweist.

Wird das vorteilhafte erfindungsgemäße Verfahren zur Verringerung von Verlusten beim Kommutierungsvorgang bei einer Wechselrichterphase 2 angewendet, für deren Stromrichterventile T1 und T2 jeweils MOSFET aus Siliziumcarbid vorgesehen sind, vereinfacht sich dieses Verfahren, da nun die Referenzspannung U_{DSref} aus einem größeren Spannungsbereich gewählt werden kann. Es muß dafür gesorgt werden, daß der Wert der Referenzspannung U_{DSref} nie gleich der Schwellspannung U_{DRD} der integralen Freilaufdiode RD1 bzw. RD2 des Stromrichterventils T1 bzw. T2 sein darf. Überschreitet die Drain-Source-Spannung U_{DS} betragsmäßig die Schwellspannung U_{DRD} der zugehörigen integralen Freilaufdiode RD, wird diese leitend, wodurch diese Freilaufdiode RD wieder am Kommutierungsvorgang mit den eingangs genannten Nachteilen beteiligt ist.

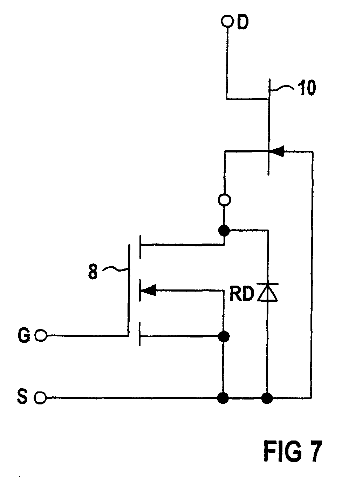

In der FIG 7 ist die Schaltung eines bekannten Hybrid-Leistungs-MOSFET näher dargestellt. Dieses Hybrid-Leistungs-MOSFET ist in der DE 196 10 135 C1 ausführlich beschrieben. Dieses Hybrid-Leistungs-MOSFET verträgt hohe Sperrspannungen, wobei die Durchlaßverluste jedoch gering sind. Dieses Hybrid-Leistungs-MOSFET weist einen selbstsperrenden n-Kanal-MOSFET 8 und einen selbstleitenden n-Kanal-Sperrschicht-FET auf. Dieser Sperrschicht-FET 10 wird auch als **J**unction-**F**ield-**E**ffect-**T**ransistor (JFET) bezeichnet. Der selbstsperrende n-Kanal-MOSFET 8 ist aus Silizium, wogegen der selbstleitende n-Kanal-JFET 10 aus Siliziumcarbid besteht. Als Si-MOSFET 8 kann ein handelsüblicher Niedervolt-Leistungs-MOSFET vorgesehen sein. Das Si-MOSFET weist eine integrale Freilaufdiode RD auf. Das Si-MOSFET 8 und das SiC-JFET 10 sind elektrisch in Reihe geschalten, wobei das Gate des SiC-JFET 10 direkt mit dem Source-Anschluß S des Si-MOSFET 8 verknüpft ist.

Das Si-MOSFET verträgt eine Sperrspannung von beispielsweise 30 V. Das dazu in Reihe geschaltete SiC-JFET 10 ist für eine sehr viel höhere Sperrspannung ausgebildet. Die geringe Sperrspannung des Si-MOSFET 8 weist auch die integrale Freilaufdiode RD auf. Eine Diode für eine geringe Sperrspannung weist eine sehr dünne Siliziumscheibe auf, woraus eine sehr geringe Speicherladung resultiert. Wegen der kaum vorhandenen Speicherladung sind die Abschaltverluste dieser integralen Freilaufdiode RD des Si-MOSFET 8 des Hybrid-Leistungs-MOSFET minimal. Aus diesem Grunde ist bei der Verwendung dieses bekannten Hybrid-Leistungs-MOSFET als Stromrichterventil T1 bzw. T2 der Wechselrichterphase 2 die Vorsteuerung des erfindungsgemäßen Verfahrens nicht mehr erforderlich. Da die Drainspannung U_{D} des Si-MOSFET 8 als Steuerspannung für den SiC-JFET 10 dient, wird dieser automatisch abgeschaltet, sobald am Si-MOSFET 8 des Hybrid-Leistungs-MOSFET eine Sperrspannung von beispielsweise 30 V ansteht.

Wenn als Stromrichterventil T1 bzw. T2 der Wechselrichterphase 2 jeweils ein Hybrid-Leistungs-MOSFET gemäß dem deutschen Patent 196 10 135 verwendet werden, kann man das in der eingangs Veröffentlichung "PCI" beschriebene Verfahren anwenden, wobei trotzdem keine hohen Verluste beim Kommutierungsvorgang auftreten. Dies ist möglich, da die Speicherladung der integralen Freilaufdiode RD des MOSFET 8 des Hybrid-Leistungs-MOSFET minimal ist. Eine Beteiligung dieser Freilaufdiode RD des MOSFET 8 am Kommutierungsvorgang ist unkritisch.

## Patentansprüche

1. Verfahren zur Verringerung von Verlusten bei der Kommutierung eines im Freilauf arbeitenden, angesteuerten Stromrichterventils (T2) einer Wechselrichterphase (2) auf ein stromübernehmendes Stromrichterventil (T1) dieser Wechselrichterphase (2), wobei zu Beginn des Kommutierungsvorgangs das stromübernehmende Stromrichterventil (T1) eingeschaltet wird und wobei das im Freilauf arbeitende, angesteuerte Stromrichterventil (T2) schnell abgeschaltet wird, sobald der Wert seiner Drainspannung (U_{D}) Null ist.

2. Verfahren nach Anspruch 1, wobei zu Beginn des Kommutierungsvorgangs die Gatespannung (U_{G}) des im Freilauf arbeitenden, angesteuerten Stromrichterventils (T2) soweit abgesenkt wird, bis seine Drainspannung (U_{D}) gleich einer vorbestimmten Referenzspannung (U_{DSref}) ist.

## Claims

1. Method for reducing losses during the commutation of a free-running, driven power converter valve (T2) of an inverter phase (2) to a current-accepting power converter valve (T1) of this inverter phase (2), whereby the current-accepting power converter valve (T1) is switched on at the beginning of the commutation process, and whereby the free-running, driven power converter valve (T2) is rapidly switched off as soon as the value of its drain voltage (U_{D}) is zero.

2. Method according to Claim 1, whereby, at the beginning of the commutation process, the gate voltage (U_{G}) of the free-running, driven power converter valve (T2) is decreased until its drain voltage (U_{D}) is equal to a predetermined reference voltage (U_{DSref}).

## Revendications

1. Procédé pour réduire des pertes lors de la commutation d'une soupape de convertisseur (T2), fonctionnant en roue libre et commandée, d'une phase d'onduleur (2) à une soupape de convertisseur (T1), prenant en charge le courant, de cette phase d'onduleur (2), dans lequel, au début de l'opération de commutation, on met à l'état passant la soupape de convertisseur (T1) prenant en charge le courant et dans lequel on met rapidement à l'état bloqué la soupape de convertisseur (T2) fonctionnant en roue libre et commandée dès que la valeur de sa tension de drain (U_{D}) devient nulle.

2. Procédé selon la revendication 1, dans lequel, au début de l'opération de commutation, on diminue la tension de grille (U_{G}) de la soupape de convertisseur (T2) fonctionnant en roue libre et commandée jusqu'à ce que sa tension de drain (U_{D}) soit égale à une valeur de référence (U_{DSref}) Prédéterminée.
